# EUROPÄISCHE PATENTSCHRIFT

(11) **EP 0 718 974 B1**
(45) Veröffentlichungstag und Bekanntmachung des Hinweises auf die Patenterteilung: **28.08.2002**
(21) Anmeldenummer: 95118234.4
(22) Anmeldetag: 18.11.1995
(51) Int. Cl.: H03K 17/94, G01S 17/02

(54) **Näherungsschalter**
Proximity switch
Commutateur de proximité

(30) Priorität: 22.12.1994 CH 388694
(43) Veröffentlichungstag der Anmeldung: 26.06.1996
(73) Patentinhaber: OPTOSYS AG, 1752 Villars-sur-Glâne (CH)
(72) Erfinder: Heimlicher, Peter, CH-1700 Freiburg (CH)
(74) Vertreter: AMMANN PATENTANWAELTE AG BERN

(56) Entgegenhaltungen:
- EP-A- 0 384 353
- DE-C- 4 027 367
- PATENT ABSTRACTS OF JAPAN vol. 018 no. 369 (E-1576) ,12.Juli 1994 & JP-A-06 098381 (DAIKIN IND LTD) 8.April 1994,

## Beschreibung

Die vorliegende Erfindung bezieht sich auf Näherungsschalter gemäss Oberbegriff des Anspruchs 1.

Optische Näherungsschalter des interessierenden Typs beinhalten im allgemeinen eine Lichtquelle und ein lichtempfindliches Element, das im weiteren als Lichtfühler bezeichnet wird. Das Licht der Lichtquelle wird bevorzugt gebündelt und in die Richtung gelenkt, die auf die Näherung eines Gegenstandes überwacht werden soll. Nähert sich ein Gegenstand aus dieser Richtung, so wird Licht von diesem reflektiert und gelangt, in der Regel ebenfalls gebündelt, auf den Lichtfühler. Mit Näherrücken des Gegenstandes erhöht sich die Intensität des reflektierten Lichtes. Bei Ueberschreiten eines Schwellwertes spricht der Näherungsschalter an.

Eine Ausführung mit Lichtleitern ist in der GB-A-2 178 840 dargestellt. Die Reichweite dieser Lösung ist jedoch gering wegen der grossen Streuung des Lichts, das aus dem Lichtleiter austritt, und dem geringen Durchmesser des lichtaufnehmenden Lichtleiters. Ausserdem nimmt die Intensität des Lichts, das auf den Näherungsschalter reflektiert wird, auch bei Unterschreiten eines bestimmten Abstands wieder ab.

Wie bereits angeführt, ist in den meisten Fällen eine Licht- und Bündelungsoptik vorhanden. Diese dient dazu, die Empfindlichkeit und damit die Entfernung zu erhöhen, in der der Näherungsschalter anspricht. Gleichzeitig wird so auch erreicht, dass auch bei Annäherung von Gegenständen mit schlecht reflektierender Oberfläche der Näherungsschalter sicher anspricht.

Bekannt ist die Verwendung von Linsen und Prismen aus der DE-A1-40 13 743. Der darin angegebene Näherungsschalter spricht auf die Anwesenheit eines Gegenstandes in einem bestimmten Raumelement an, das durch den Schnitt des ausgesandten Lichtbündels mit dem Beobachtungsfeld des Lichtfühlers definiert ist. Das enthaltene Linsensystem dient zur Bündelung des Lichts der Lichtquelle bzw. des auf den Schalter zurückreflektierten Lichts auf den Lichtfühler. Durch Verdrehen des Prismas ist es möglich, den Abstand des Raumelementes vom Näherungsschalter einzustellen.

Ein Nachteil der bekannten Ausführung besteht in der beschränkten Miniaturisierbarkeit, da jeweils eine Linse für Lichtquelle und Lichtfühler vorhanden sein muss, die nicht beliebig klein gewählt werden können und eine ungünstige Ausnutzung des gesamten, zur Verfügung stehenden Querschnitts aufweisen.

Eine Aufgabe der vorliegenden Erfindung besteht darin, einen Näherungsschalter anzugeben, der kleinere Bauformen bei bestmöglichen Ansprechwerten erlaubt.

Ein derartiger Näherungsschalter ist im Anspruch 1 angegeben. Die weiteren Ansprüche beziehen sich auf bevorzugte Ausführungsformen.

Allgemein weist der erfindungsgemässe Näherungsschalter einen unterteilten Hohlspiegel als optisches Bündelungs- und Richtelement auf. Ein Teil des Hohlspiegels wird von der Lichtquelle beleuchtet, bündelt das Licht und richtet es in die Beobachtungsrichtung. Ein zweiter Teil des Hohlspiegels dient dazu, das auf den Näherungsschalter fallende Licht, z. B. das vom sich nähernden Gegenstand reflektierte, auf den Lichtfühler zu konzentrieren. Durch diese Vereinigung der nötigen Optik in einem einzigen optischen Element, dem Hohlspiegel, in Verbindung mit den kleinen möglichen Bauformen von Lichtquellen und Lichtfühlern, z. B. LED's und Optotransistoren, kann der erfindungsgemässe Näherungsschalter sehr klein und kompakt ausgeführt werden.

Die Erfindung wird weiter anhand von Ausführungsbeispielen unter Bezugnahme auf Figuren erläutert.
Figur 1 zeigt einen Schnitt durch den erfindungsgemässen Näherungsschalter;
Figur 2 zeigt eine Aufsicht zum Vergleich der Ausführung mit Linsen und der erfindungsgemässen Ausführung;
Figur 3 ist ein Schnitt durch eine einfache Ausführung eines Näherungsschalters; und
Figur 4 zeigt einen Schnitt durch eine andere Ausführung des Näherungsschalters.

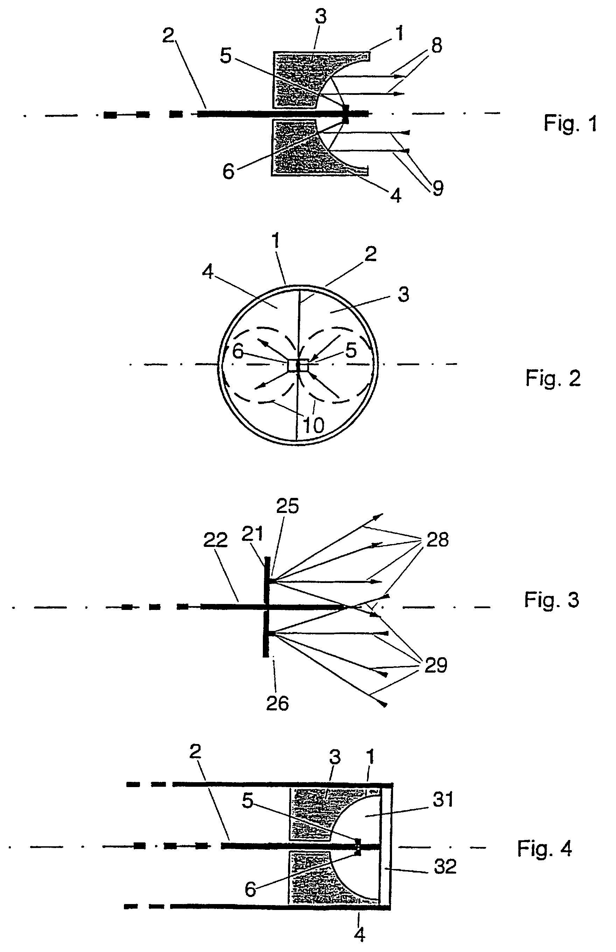

Gemäss dem in Figur 1 dargestellten, prinzipiellen Aufbau eines erfindungsgemässen Näherungsschalters besteht dieser aus einem Hohlspiegel 1, der durch eine Trägerplatte 2 in zwei Hälften 3 und 4 geteilt ist. Auf der Oberseite der Trägerplatte 2 befindet sich eine Lichtquelle 5, z. B. eine Lichtemissionsdiode (LED), und auf der Unterseite ein Lichtfühler 6, z. B. ein Fototransistor oder eine Fotodiode. Bevorzugt weist die Trägerplatte 2 die nötigen elektrischen Verbindungsleitungen für Lichtquelle 5 und Lichtfühler 6 auf. Sie kann insbesondere auch eine Platine für gedruckte Schaltungen sein, so dass die übrigen, elektronischen Bauelemente (nicht dargestellt) des Näherungsschalters ebenfalls auf der Trägerplatte 2 angeordnet werden können.

Das von der Lichtquelle 5 ausgestrahlte Licht wird von der oberen Hohlspiegelhälfte umgelenkt und als Lichtbündel 8 abgestrahlt. Nähert sich nun ein Körper mit z. B. diffus reflektierender Oberfläche dem Näherungsschalter, so wird von dem auf ihn fallenden Licht 8 ein gewisser Anteil zurück auf die untere Hohlspiegelhälfte 4 des Näherungsschalters reflektiert. Der untere Hohlspiegel 4 konzentriert das einfallende Licht 9 weitgehend auf den Lichtfühler 6. Mit zunehmender Annäherung des Körpers erhöht sich die auf den Näherungsschalter reflektierte Lichtmenge, so dass bei einem bestimmten Abstand ein Schwellwert an Intensität am Lichtfühler 6 überschritten wird und der Näherungsschalter ein Signal erzeugt.

Für die Funktion des Näherungsschalters ist es anzustreben, einen möglichst grossen Teil des gesamten, von der Lichtquelle erzeugten Lichts in die Ueberwachungsrichtung zu lenken, und umgekehrt eine möglichst effiziente Bündelung des reflektierten Lichts auf den Lichtfühler zu erzielen, um u. a. den Verlust an Lichtintensität bei der Reflexion am sich nähernden Objekt zu kompensieren.

Um zu verhindern, dass Licht von der Lichtquelle 5 direkt auf den Lichtfühler 6 gelangt, ist die Trägerplatte 2 für das Licht der Lichtquelle undurchdringlich und durchtrennt bevorzugt den Spiegel vollständig.

Lichtfühler 6 und Lichtquelle 5 sind jeweils möglichst im Brennpunkt der jeweiligen Hohlspiegelhälften angeordnet. Dadurch wird das abgestrahlte Licht in etwa parallel zur optischen Achse abgestrahlt, und auch die Lichtfühlergruppe, bestehend aus dem Lichtfühler 6 und der unteren Hohlspiegelhälfte 4, weist für solches Licht eine maximale Empfindlichkeit auf. Die optische Achse ist dabei jeweils durch die Verbindungslinie zwischen dem Brennpunkt und dem nächstliegenden Punkt des Hohlspiegels gegeben, der gegebenenfalls durch virtuelle Ergänzung der jeweiligen Hohlspiegelhälfte erhalten wird. Gemäss der dargestellten, beispielhaften Ausführungsform fallen die optischen Achsen der beiden Hohlspiegelhälften zusammen.

Der Vorteil des erfindungsgemässen Näherungsschalters zeigt sich bei Betrachtung von Figur 2, die eine schematische Aufsicht auf einen erfindungsgemässen Näherungsschalter darstellt. Gestrichelt angedeutet sind zwei Linsen 10, wie sie ein Näherungsschalter herkömmlicher Bauweise gleicher Einbaugrösse aufweisen würde. Bezeichnet man den Durchmesser des Hohlspiegels 1 mit d, so weist dieser eine Querschnittsfläche von 1/4 π d² auf. Als Austrittsfläche für das abgestrahlte Licht 8, bzw. Einfangquerschnitt für das reflektierte Licht 9, ergibt sich daraus jeweils ein Wert von 1/8 π d².

Der Sensor herkömmlicher Bauweise wies dagegen jeweils nur die Querschnittsfläche der Linsen 10 auf, die jeweils einen Durchmesser von d/2 besitzen und demnach eine Durchtrittsfläche von 1/4 π (d/2)² = 1/16 π d². Die für Lichtein- und -austritt verfügbaren Flächen sind also bei dem erfindungsgemässen Näherungsschalter doppelt so gross wie bei der herkömmlichen Bauart mit Linsen.

Ein weiterer Unterschied resultiert aus der Tatsache, dass die optischen Achsen der Linsen einen Abstand von d/2 aufweisen, während beim erfindungsgemässen Näherungsschalter gemäss dem Ausführungsbeispiel nur eine optische Achse vorhanden ist. Es steht zu erwarten, dass hierdurch bedingt auch dann, wenn sich ein Objekt sehr nahe vor dem Sensor befindet, noch genug Licht auf den Lichtfühler reflektiert wird, um die Schaltschwelle zu überschreiten. Bei den herkömmlichen Bauweisen ist dagegen, sofern nicht Justierungen speziell für den Nahbereich durchgeführt werden, mit einem Abfall der Belichtungsintensität bei sehr nahem Objekt zu rechnen.

Figur 3 zeigt schliesslich einen sehr stark vereinfachten Aufbau, der bei der Entwicklung des vorliegenden Näherungsschalters als Ausgangspunkt diente. Eine Lichtquelle 25 und ein Lichtfühler 26 befinden sich auf einem ebenen, plattenförmigen Träger 21. Dazwischen befindet sich wiederum eine Trennwand 22, die in etwa senkrecht auf dem Träger 21 steht und für das Licht der Lichtquelle 25 im wesentlichen undurchlässig ist. Sowohl Träger 21 wie Trennwand 22 weisen die nötigen elektrischen Verbindungsleitungen für Lichtquelle 25 und Lichtfühler 26 auf. Sie können insbesondere gedruckte Leiterplatten sein. Diese Ausführung weist, ausser der Richtcharakteristik der Lichtquelle 25 für das ausgestrahlte Licht 28 und des Lichtfühlers 26 für das wahrgenommene Licht 29 keinerlei Bündelungs- oder Richtelemente auf. Es zeigte sich jedoch, dass mit den gegenwärtig verfügbaren Lichtquellen bzw. Lichtfühlern keine ausreichende Empfindlichkeit des Näherungsschalters erreicht werden kann. Auch ist es nötig, zwei Platten, nämlich die Trennwand 22 und den Träger 21 mit Leiterbahnen zu versehen und Lichtquelle 25 und Lichtfühler 26 in einem geeigneten Abstand voneinander anzuordnen. Dadurch ist es ausgeschlossen, diese beiden Elemente zusammen mit den übrigen nötigen Bauteilen in einer miniaturisierten Schaltung zusammenzufassen.

Die beschriebene, bevorzugte Ausführungsform des Näherungsschalters erlaubt eine Vielzahl von Modifikationen, ohne das erfindungsgemässe Konzept zu verlassen, wovon einige besonders hervorstechende im folgenden aufgeführt werden.

Die optische Trennung von Lichtquelle 5 und Lichtfühler 6 kann auch dadurch gewährleistet werden, dass diese eine entsprechende Richtcharakteristik aufweisen, wonach der Träger 2 nicht den Spiegel vollständig unterteilt oder auch zurückversetzt sein kann. Die beiden Spiegelhälften 3 und 4 können auch unterschiedlich geformt sein und sphärisch, parabolisch oder in einer beliebigen anderen Form ausgebildet sein, soweit die Funktion der Bündelung und Ausrichtung des abgestrahlten bzw. einfallenden Lichts gewahrt bleibt. Denkbar ist auch, dass diese Spiegelhälften nicht aus einer zentralen Teilung eines Hohlspiegels hervorgehen, sondern jeweils einen Abschnitt eines Hohlspiegels darstellen, der nicht mittig geteilt wurde, so dass z. B. die Hohlspiegelteile nicht mehr übereinstimmende optische Achsen aufweisen.

Es ist auch denkbar, nur die direkte Einstrahlung des Lichts der Lichtquellen auf den Lichtfühler zu verhindern und einen einzigen, nicht unterteilten Hohlspiegel zu verwenden. Vorbedingung hierfür ist, dass nur ein geringer Teil des von der Lichtquelle ausgehenden Lichts direkt oder indirekt über Reflexion am Spiegel und/oder sonstigen Teilen des Näherungsschalters auf den Lichtfühler gelangt, so dass bei Annäherung eines Gegenstandes eine merkliche, auswertbare Erhöhung der Lichtintensität am Lichtfühler auftritt.

Ohne weiteres einsichtig ist, anstatt einer einzigen, im wesentlichen punktuellen Lichtquelle 5 bzw. eines derartigen Lichtfühlers 6 eine Mehrzahl derartiger Quellen bzw. Fühler einzusetzen. In diesem Zusammenhang ist es auch denkbar, jeweils einer Lichtquelle bzw. einem Lichtfühler oder einer Gruppe derselben jeweils einen Hohlspiegelabschnitt 3 bzw. 4 zuzuordnen, d. h., im einfachsten Falle den Hohlspiegel 1 in eine entsprechende Anzahl Segmente zu unterteilen. Sofern diese Unterteilung derart geschieht, dass sich Lichtquellen und Lichtfühler abwechseln, z. B. bei einer Vierteilung die Lichtquelle in Quadranten 1 und 3 und die Lichtfühler in Quadranten 2 und 4, ist u. a. mit einer verbesserten Empfindlichkeit im Nahbereich zu rechnen. Die Unterteilung des Hohlspiegels 1 muss auch nicht symmetrisch sein, sondern es kann der Lichtquelle durch entsprechende Auslegung der Unterteilung ein grösserer oder kleinerer Anteil der Spiegelfläche zugeordnet werden als dem Lichtfühler. Hierdurch können z. B. Unterschiede im Oeffnungswinkel von Lichtquelle und Lichtfühler ausgeglichen bzw. für eine optimale Nutzung der Spiegelfläche ausgenutzt werden.

Lichtquelle und Lichtfühler können auch an anderer Stelle positioniert werden, um z. B. eines oder beide der folgenden Ziele zu erreichen:
- Neigen der optischen Achsen der Hohlspiegelteile gegeneinander, um ein überwachtes Raumelement durch die Lage des Schnittpunktes zu definieren. Hier ist auch bevorzugt vorzusehen, die Hohlspiegelteile mit einem gewissen Abstand voneinander anzuordnen, um einen stumpferen Schnittwinkel zu erhalten.
- Streuungs- oder Bündelungscharakteristik für abgestrahltes und/oder eingefangenes Licht, z. B. zur Einstellung der Ansprechentfernung.

Als Lichtquelle kommen alle gängigen Formen in Frage, also neben lichterzeugenden Halbleiterbauelementen z. B. auch Glüh- oder Glimmlampen. Insbesondere sind auch Laserlicht emittierende Lichtquellen wie Laserdioden verwendbar, mit denen ein abgestrahltes Lichtbündel geringer Dispersion erzielbar ist. Ebenso sind auch für die Lichtfühler im wesentlichen alle gängigen Bauelemente verwendbar, insbesondere solche, die ein Signal in Abhängigkeit von der aufgenommenen Intensität abgeben. Für miniaturisierte Ausführungen empfehlen sich sowohl für Lichtquelle als auch Lichtfühler Halbleiterelemente, insbesondere solche, die sich mit einem Teil der nötigen Steuerungs- und Versorgungsschaltung in einer integrierten Schaltung vereinigen lassen. Als Extremfall ist es sogar denkbar, Lichtquelle und -fühler auf ein- und derselben integrierten Schaltung vorzusehen, wobei diese z. B. durch das Substrat oder eine entsprechende Trennwand oder Richtcharakteristik optisch entkoppelt sind.

Der Hohlspiegel kann auf im wesentlichen alle gängigen Arten hergestellt sein, kann also neben vorne oder hinten metallbeschichtetem Glas insbesondere auch aus metallbeschichtetem Kunststoff bestehen. Zur Erhöhung der Widerstandsfähigkeit gegen Umwelteinflüsse kann der Spiegel mit einer Masse ausgefüllt werden, die zumindest für das Licht der Lichtquelle im wesentlichen transparent ist. Hierfür bieten sich insbesondere transparente Giessharze an.

Eine derartige Ausführung zeigt Figur 4. Insoweit hier Uebereinstimmung mit der Ausführung gemäss Figur 1 vorliegt, wurden gleiche Bezugszeichen angebracht. Das Innere des Hohlspiegels 1 ist mit einer Vergussmasse 31 ausgefüllt, die für das Licht durchlässig ist, das die Lichtquelle 5 abstrahlt. Um eine Streuung des Lichts beim Aus- und Eintritt aus bzw. in die Vergussmasse zu vermeiden, wird eine plane Grenzfläche durch die Glasscheibe 32 sichergestellt.

Anstelle Glas kann für die Scheibe 32 auch anderes Material verwendet werden, bevorzugt solches, aus dem die benötigten Scheiben einfach hergestellt werden können. Denkbar ist in diesem Zusammenhang z. B. Quarzglas, Acrylglas oder auch vorgefertigte Scheiben aus dem Material, das zum Füllen des Hohlspiegels verwendet wird. Da hierbei nur eine allenfalls geringe Differenz der Brechungsindices beim Uebertritt von Licht zwischen der Masse 31 und die Scheibe 32 auftritt, können hierbei auch die Anforderungen an die Planizität dieser Grenzfläche geringer gehalten werden. Ansonsten ist für optimale Effektivität auch bei dieser inneren Grenzfläche eine grösstmögliche Planizität vorzuziehen.

Nicht ausgeschlossen ist auch, nur die Scheibe 32 vorzusehen und den Hohlspiegel nicht auszufüllen. Zusätzlich können auch noch übliche Abdichtungsvorkehrungen getroffen werden, um eine weitgehende, möglichst hermetische Versiegelung des Sensors zu erreichen.

Nicht zu vergessen ist, dass der vorliegende Hohlspiegel durch seine im wesentlichen runde Form optimal geeignet ist, z. B. mit einem Aussengewinde versehen zu werden und dadurch in eine Oberfläche eingeschraubt werden kann. Andere Formen sind z. B. Renk- oder Bajonettverschlüsse. Die Kontaktierung des Näherungsschalters erfolgt auf eine der üblichen Arten, z. B. über Steckkontakte oder Anschlusskabel.

## Patentansprüche

1. Näherungsschalter mit mindestens einer Lichtquelle (5) und mindestens einem Lichtfühler (6), **dadurch gekennzeichnet, dass** der Lichtquelle (5) ein erster Teil (3) eines Hohlspiegels (1) und dem Lichtfühler ein zweiter Teil (4) des Hohlspiegels zugeordnet ist, derart, dass von der Lichtquelle (5) ausgehendes Licht (8) von dem ersten Hohlspiegelteil (3) in eine zu überwachende Richtung gelenkt wird, und bei Annäherung eines Gegenstandes aus dieser Richtung von diesem in Richtung des Näherungsschalters reflektiertes Licht (9) von dem zweiten Hohlspiegelteil (4) auf den Lichtfühler (6) gelenkt wird.

2. Näherungsschalter gemäss Anspruch 1, **dadurch gekennzeichnet, dass** das erste und zweite Hohlspiegelteil (3, 4) durch optische Teilung des Hohlspiegels (1) ausgebildet sind, wobei die optische Teilung verhindert, dass solche Lichtmengen, die ein Ansprechen des Näherungsschalters auslösen, von der Lichtquelle (5) auf den Lichtfühler (6) gelangen, ohne von einem sich nähernden Gegenstand reflektiert worden zu sein.

3. Näherungsschalter gemäss Anspruch 2, **dadurch gekennzeichnet, dass** die Trennung aus im wesentlichen parallel zur Achse des Hohlspiegels (1) ausgerichteten Wänden (2) besteht.

4. Näherungsschalter gemäss Anspruch 2 oder 3, **dadurch gekennzeichnet, dass** die Trennung für zumindest das von der Lichtquelle (5) abgestrahlte Licht undurchlässig ist.

5. Näherungsschalter gemäss Anspruch 1, **dadurch gekennzeichnet, dass** erster (3) und zweiter (4) Teil des Hohlspiegels (1) zumindest teilweise bis vollständig überlappen.

6. Näherungsschalter gemäss einem der Ansprüche 1 bis 5, **dadurch gekennzeichnet, dass** Lichtquelle (5) und/oder Lichtfühler (6) nahe oder in dem Brennpunkt des jeweiligen Hohlspiegelteils (3, 4) angeordnet ist.

7. Näherungsschalter gemäss einem der Ansprüche 1 bis 6, **dadurch gekennzeichnet, dass** Lichtquelle (5) und Lichtfühler (6) optoelektronische Bauelemente sind, die auf der Vorder- bzw. Rückseite einer in den Hohlspiegel (1) ragenden Trägerplatte (2) angebracht sind, wobei die Trägerplatte (2) im wesentlichen die optische Trennung ist.

8. Näherungsschalter gemäss einem der Ansprüche 1 bis 7, **dadurch gekennzeichnet, dass** erste (3) und zweite (4) Spiegelteile gleich sind und durch die optische Trennung (2) aus dem Hohlspiegel (1) durch symmetrische Teilung hervorgegangen sind.

9. Näherungsschalter gemäss einem der Ansprüche 1 bis 8, **dadurch gekennzeichnet, dass** die Hohlspiegelteile (3, 4) mit einer zumindest für das von der Lichtquelle (5) abgestrahlte Licht transparenten Masse gefüllt sind.

10. Näherungsschalter gemäss einem der Ansprüche 1 bis 9, **dadurch gekennzeichnet, dass** die Spiegelteile (3, 4) konkav sind und parabolische oder sphärische Form aufweisen.

11. Näherungsschalter gemäss einem der Ansprüche 1 bis 10, **dadurch gekennzeichnet, dass** die Oeffnung des Hohlspiegels (1) vollständig durch eine Scheibe (32) abgedeckt ist, die zumindest für das von der Lichtquelle (5) ausgesandte Licht transparent ist.

12. Näherungsschalter gemäss Anspruch 11, **dadurch gekennzeichnet, dass** zumindest die eine Aussenfläche des Schalters darstellende Oberfläche der Scheibe (32) im wesentlichen plan ist, um eine geringe Streuung beim Lichtübergang sicherzustellen.

## Claims

1. Proximity switch, comprising at least one light source (5) and at least one light sensor (6), **characterised in that** a first portion (3) of a concave mirror (1) is associated to the light source (5) and a second portion (4) of the concave mirror is associated to the light sensor in such a manner that the light (8) emitted by the light source (5) is directed by the first portion (3) of the concave mirror in a direction to be monitored, and the light (9) reflected towards the proximity switch by an object approaching from that direction is directed onto the light sensor (6) by the second portion (4) of the concave mirror.

2. Proximity switch according to claim 1, **characterised in that** the first and the second portion (3, 4) of the concave mirror are formed by an optical separation of the concave mirror (1), the optical separation preventing that such amounts of light as would trigger a response of the proximity switch may pass from the light source (5) to the light sensor (6) without having been reflected by an approaching object.

3. Proximity switch according to claim 2, **characterised in that** the separation consists of walls (2) extending in parallel to the axis of the concave mirror (1) essentially.

4. Proximity switch according to claim 2 or 3, **characterised in that** the separation is impermeable at least to the light emitted by the light source (5).

5. Proximity switch according to claim 1, **characterised in that** the first (3) and the second (4) portion of the concave mirror (1) overlap at least partially or completely.

6. Proximity switch according to any one of claims 1 to 5, **characterised in that** the light source (5) and/or the light sensor (6) is/are disposed near or in the focus of the respective portion (3, 4) of the concave mirror.

7. Proximity switch according to any one of claims 1 to 6, **characterised in that** the light source (5) and the light sensor (6) are optoelectronic components mounted on the front resp. on the back side of a support plate (2) projecting into the concave mirror, the support plate (2) essentially constituting the optical separation.

8. Proximity switch according to any one of claims 1 to 7, **characterised in that** the first (3) and the second (4) mirror portions are equal and result from the optical separation (2) of the concave mirror (1) by a symmetrical division.

9. , Proximity switch according to any one of claims 1 to 8, **characterised in that** the portions (3, 4) of the concave mirror are filled with a substance that is transparent at least for the light emitted by the light source (5).

10. Proximity switch according to any one of claims 1 to 9, **characterised in that** the mirror portions (3, 4) are concave and have a parabolical or spherical shape.

11. Proximity switch according to any one of claims 1 to 10, **characterised in that** the opening of the concave mirror (1) is completely covered by a plate (32) that is transparent at least for the light emitted by the light source (5).

12. Proximity switch according to claim 11, **characterised in that** at least the surface of the plate (32) representing an external surface of the switch is essentially plane in order to ensure a small dispersion in the light transit.

## Revendications

1. Détecteur de proximité, comprenant au moins une source de lumière (5) et au moins un photodétecteur (6), **caractérisé en ce qu'**une première partie (3) d'un miroir concave (1) est associée à la source de lumière (5) et une deuxième partie (4) dudit miroir concave est associée au photodétecteur, de manière que la lumière émise par la source de lumière (5) est dirigée par la première partie (3) du miroir concave dans une direction à surveiller, et que la lumière (9) réfléchie vers le détecteur de proximité par un objet approchant de ladite direction est conduite par la deuxième partie (4) du miroir concave sur le photodétecteur (6).

2. Détecteur de proximité selon la revendication 1, **caractérisé en ce que** la première et la deuxième partie (3, 4) du miroir concave sont formées par une division optique du miroir concave (1), ladite division évitant le passage de la source de lumière (5) au photodétecteur (6) de telles quantités de lumière qui pourraient provoquer une réponse du détecteur de proximité sans avoir été réfléchies par un objet approchant.

3. Détecteur de proximité selon la revendication 2, **caractérisé en ce que** ladite séparation consiste de parois (2) d'orientation essentiellement parallèle à l'axe du miroir concave (1).

4. Détecteur de proximité selon la revendication 2 ou 3, **caractérisé en ce que** la séparation est opaque au moins à la lumière émise par la source de lumière (5).

5. Détecteur de proximité selon la revendication 1, **caractérisé en ce que** la première (3) et la deuxième (4) partie du miroir concave (1) se recouvrent d'au moins partiellement jusqu'à entièrement.

6. Détecteur de proximité selon l'une des revendications 1 à 5, **caractérisé en ce que** la source de lumière (5) et/ou le photodétecteur (6) sont disposés à proximité ou dans le foyer de la partie (3, 4) correspondante du miroir concave.

7. Détecteur de proximité selon l'une des revendications 1 à 6, **caractérisé en ce que** la source de lumière (5) et le photodétecteur (6) sont des composantes optoélectroniques montées sur la face avant resp. arrière d'une plaque de support (2) en saillie dans le miroir concave (1), ladite plaque de support (2) constituant essentiellement la séparation optique.

8. Détecteur de proximité selon l'une des revendications 1 à 7, **caractérisé en ce que** la première (3) et la deuxième (4) partie du miroir sont égales et résultent de la séparation (2) optique du miroir concave (1) par une division symétrique.

9. Détecteur de proximité selon l'une des revendications 1 à 8, **caractérisé en ce que** les parties (3, 4) du miroir concave sont remplies d'une substance transparente au moins à la lumière émise par la source de lumière (5).

10. Détecteur de proximité selon l'une des revendications 1 à 9, **caractérisé en ce que** les parties (3, 4) du miroir sont concaves et présentent une forme parabolique ou sphérique.

11. Détecteur de proximité selon l'une des revendications 1 à 10, **caractérisé en ce que** l'ouverture du miroir concave (1) est entièrement recouverte d'une plaque (32) laquelle est transparente au moins à la lumière émise par la source de lumière (5).

12. Détecteur de proximité selon la revendication 11, **caractérisé en ce que** du moins la surface de la plaque (32) qui constitue une surface extérieure du détecteur est essentiellement plane afin d'assurer une faible dispersion au passage de la lumière.
